# FASCICULE DE BREVET EUROPEEN

(11) **EP 0 720 224 B1**
(45) Date de publication et mention de la délivrance du brevet: **28.11.2007**
(21) Numéro de dépôt: 95402901.3
(22) Date de dépôt: 21.12.1995
(51) Int. Cl.: H01L 23/40

(54) **Procédé et dispositif de fixation de deux éléments tels qu'un radiateur de circuit intégré à une carte de circuits imprimés**
Verfahren und Anordnung zur Befestigung von zwei Elementen, wie einem integrierten Schaltungsstrahler, auf einer gedruckten Schaltungskarte
Method and device for fixing two elements such as an integrated circuit radiator to a printed circuit card

(30) Priorité: 29.12.1994 FR 9415886
(43) Date de publication de la demande: 03.07.1996
(73) Titulaire: BULL S.A., 78430 Louveciennes (FR)
(72) Inventeur: Dehaine, Gérard, F-92320 Châtillon (FR); Stricot, Yves, F-78340 Les Clayes sous Bois (FR)
(74) Mandataire: Debay, Yves

(56) Documents cités:
- EP-A- 0 236 065
- EP-A- 0 508 179
- EP-A- 0 654 822
- DE-A- 2 841 370
- US-A- 4 342 068
- US-A- 5 109 317

## Description

### Domaine technique

L'invention a pour objets un procédé et un dispositif de fixation de deux éléments entre eux enserrant un composant électrique ou électronique pour exercer sur le composant une force de contact. Le contact peut être thermique et concerner les dispositifs d'évacuation de la chaleur dissipée par le composant, appelés radiateurs. L'invention se rapporte alors plus particulièrement aux dispositifs de fixation d'un radiateur à une carte de connexion de ce composant. L'invention sera bien mise en relief dans la suite du texte en se référant, comme exemple illustratif, aux dispositifs de fixation d'un radiateur à ailettes à une carte de circuits imprimés. Dans ce contexte, invention a pour objets corollaires un radiateur et une carte de connexion. Cependant, le contact peut aussi être électrique, l'un des éléments servant par exemple d'électrode d'alimentation en tension du composant.

### L'art antérieur

On connaît déjà de nombreux dispositifs de fixation de radiateurs à une carte de circuits imprimés. Ils peuvent être classés en divers types selon leur adaptation à diverses contraintes. Le type de dispositif de fixation concerné par invention doit être adapté à une fixation amovible simple, efficace, fiable et pouvant être de faible coût. Les critères d'efficacité concernent principalement la force de contact exercée sur le composant entre le radiateur et la carte. De préférence, on souhaite dans de nombreux cas que la force de contact soit aisément ajustable à une valeur désirée sensiblement constante. Dans certains cas, il est aussi avantageux que l'ajustement de la force de contact puisse s'adapter à divers types de composants, déterminés par exemple par leur épaisseur. Il peut encore s'avérer souhaitable que la force de contact soit peu sensible aux défauts de planéité du radiateur et/ou de la carte et/ou du composant. Il peut même être demandé que la force de contact soit indépendante de épaisseur du composant dans des limites prédéterminées ou raisonnables. Un autre facteur important qui peut être demandé en plus concerne l'indépendance entre la force de contact désirée du radiateur sur le composant et la force de fixation désirée du dispositif de fixation à la carte. Un autre facteur qui peut intervenir concerne le degré de sensibilité de la fixation aux vibrations de la carte. Dans certains cas, il faut encore que le dispositif de fixation soit adapté au mode de connexion du composant. Par exemple, si le composant est un circuit intégré monté sur la carte par l'intermédiaire de fils ou pattes (leads) conducteurs, le dispositif de fixation du radiateur ne doit pas modifier ou influer sur ce montage. Une autre caractéristique importante peut concerner la disponibilité du dispositif de fixation sur le radiateur ou sur la carte. Il est en effet souhaitable que tous les éléments du dispositif de fixation soient présents sur le radiateur et/ou sur la carte. Ceci facilite la manipulation et la manoeuvre de fixation. Mais il ne faut pas que la présence de ces éléments puisse interférer avec la présence du composant ou de son montage sur la carte. De préférence aussi, le dispositif de fixation conviendra aux radiateurs de grande surface, tels que les radiateurs pour boîtiers de circuits intégrés de haute dissipation thermique. Parmi tous les radiateurs connus de ce type, aucun ne satisfait pleinement à toutes ces conditions.

Le document DE-A-2841370 décrit un dispositif de fixation d'un premier élément et d'un second élément entre eux pour enserrer un composant électrique ou électronique. Au moins l'un des deux éléments est un radiateur à ailettes. Le premier élément est traversé par des vis formant des moyens d'attache au second élément et porte des moyens à ressort. Selon un premier mode de réalisation, les deux éléments sont fixés par les vis pour enserrer le composant, et les moyens à ressort sont des ressorts à disques contenus avec un piston dans un écrou se vissant dans le premier élément pour que le piston vienne en contact avec le composant et comprime les ressorts pour exercer sur le composant la pression désirée quand l'écrou vient en butée contre le premier élément. Selon un second mode de réalisation, le premier élément est fixé au second élément par les vis pour enserrer le composant, et les moyens à ressort sont disposés pour s'appuyer sur le premier élément et sur des écrous montés sur les vis et sont comprimés par vissage des écrous pour exercer sur le composant la pression désirée lorsque les écrous viennent en butée contre le premier élément. Dans ces deux modes de réalisation, les ressorts n'exercent aucune pression avant la fixation des deux éléments et ne sont comprimés qu'au moment de la fixation des deux éléments entre eux.

### L'invention.

L'invention permet de satisfaire à tout ou partie des exigences précédentes, de façon simple, efficace, fiable, et pouvant être peu coûteuse et de s'appliquer plus généralement à deux éléments dont l'un au moins exerce sur un composant électrique ou électronique une force de contact de nature thermique et/ou électrique.

Elle a pour objet un dispositif de fixation de deux éléments enserrant un composant électrique ou électronique, le dispositif de fixation étant défini par la revendication 1. L'invention a pour objet corollaire un radiateur tel que défini par la revendication 7.

L'invention a encore pour objet corollaire une carte telle que définie par la revendication 8 ou 9.

Les caractéristiques et avantages de l'invention ressortent de la description qui suit, donnée à titre d'exemple et faite en référence aux dessins annexés. Dans ces dessins :
- la figure 1 est une vue en coupe schématique d'un dispositif conforme à invention pour la fixation d'un radiateur à une carte de connexion pourvu d'un circuit intégré à refroidir, illustrant le radiateur hors de la carte et en position pour son montage ultérieur sur la carte;
- les figures 2a et 2b sont des vues semblables à celles de la figure 1, illustrant deux étapes principales du procédé de fixation conforme à invention ; et
- la figure 3 est un graphe représentatif des variations de la force exercée par chaque ressort utilisé dans le dispositif de fixation représenté sur les figures 1, 2a et 2b en fonction de leur élongation et illustrant un mode de réglage de la force exercée par ces ressorts sur le radiateur.

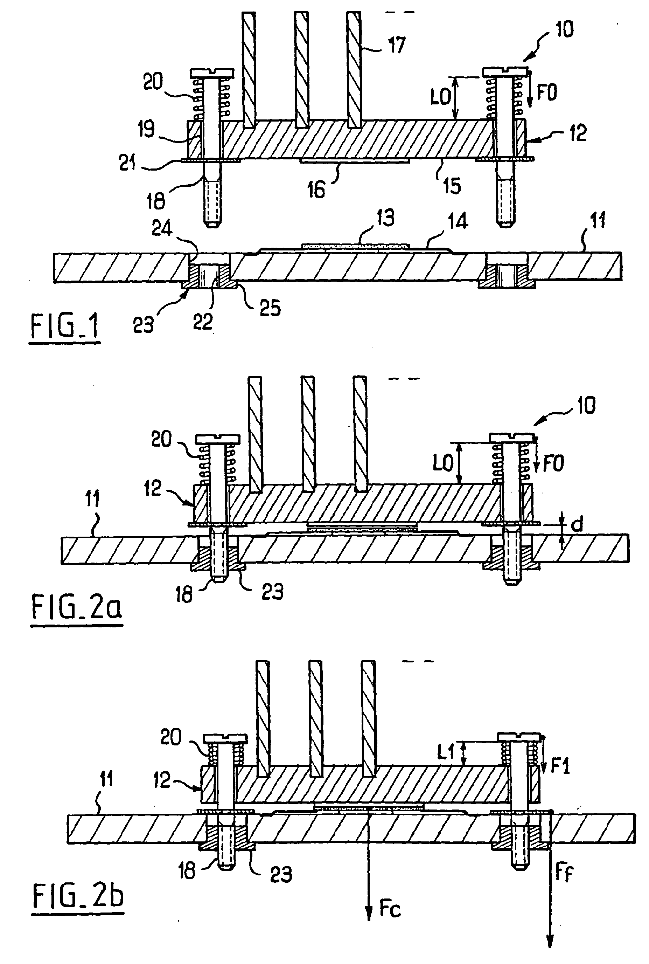

La figure 1 représente un dispositif de fixation 10 entre une carte de circuits imprimés 11 et un radiateur 12 prévu pour le refroidissement d'un composant 13 destiné à être monté sur la carte 11. On a supposé que le composant 13 est déjà monté sur la carte 11 et que ce composant est un circuit intégré pourvu de pattes 14 dont les extrémités sont connectées à la carte. La face active qui porte le circuit d'interconnexion du circuit intégré 13 est placée en vis-à-vis de la face correspondante de la carte 11. Le radiateur 12 est destiné à venir en contact contre la face opposée, non active, du circuit intégré 13, directement ou par l'intermédiaire d'une interface thermique bien connue. On supposera que le contact se fait par l'intermédiaire d'une interface (non représentée) sous forme d'une couche nécessitant une force de contact Fc prédéterminée pour obtenir une résistance thermique prédéterminée. Le radiateur 12 illustré se présente sous la forme d'une plaque métallique 15, par exemple en aluminium et de section carrée, dont la face en vis-à-vis du circuit intégré 13 est pourvue d'une sole 16 légèrement surélevée et adaptée à former un bon contact thermique avec la face correspondante du circuit intégré. La face opposée du radiateur 12 est pourvue d'ailettes 17 encastrées perpendiculairement dans la plaque 15.

Le dispositif de fixation 10 illustré comprend quatre vis 18 traversant la plaque 15 dans des trous 19 disposés aux quatre coins de la plaque. La tête de chaque vis 18 est placée du côté des ailettes 17 et a une section plus grande que le corps adjacent de façon à former un rebord. Le dispositif de fixation 10 comprend aussi quatre ressorts hélicoïdaux 20. Chaque ressort hélicoïdal 20 est placé coaxialement à la vis et a ses deux extrémités s'appuyant respectivement sur la plaque 15 et sur le rebord de la tête de la vis 18. De l'autre côté de la plaque 15, chaque vis 18 est pourvue d'un moyen de couplage avec le radiateur, ayant dans l'exemple illustré la forme d'une butée 21 constituée par le clip illustré, engagé dans une gorge ménagée dans le corps de la vis à une distance prédéterminée de la tête de vis et identique pour chaque vis. Cette distance correspond à une longueur L0 de chaque ressort 20 entre la tête de vis et la plaque 15. Le corps de chaque vis 18 se termine par une partie filetée placée en dessous du clip 21. La carte 11 est pourvue de trous 22 destinés à recevoir les extrémités filetées des vis correspondantes 18. L'emplacement des trous 22 sur la carte détermine la position du radiateur par rapport au circuit intégré 13. Chaque trou 22 est fileté et constitue, dans l'exemple illustré, le trou intérieur d'un écrou 23 fixé dans un trou 24 de la carte 11. Chaque écrou 23 a une extrémité formant un rebord servant de butée contre la face opposée de la carte.

Dans la figure 1, le radiateur 12 est illustré dans son état hors de la carte 11, par exemple dans l'état où il a été acheté. Dans cet état, les ressorts 20 sont comprimés de façon que la somme des forces F0 qu'ils exercent entre les têtes des vis 18 et le radiateur 12 corresponde sensiblement à la force de contact Fc prédéterminée du radiateur 12 contre le circuit intégré 13. La force F0 est donc appliquée constamment à une valeur quelconque désirée avant son montage sur la carte. Dans la figure 1, les vis 18 du radiateur sont aussi illustrées en correspondance avec les trous 22 de la carte 11. Il suffit donc d'approcher le radiateur 12 de la carte 11 pour procéder au montage du radiateur sur la carte. Les figures 2a et 2b illustrent des étapes du procédé de fixation du radiateur 12 à la carte 11. La figure 2a représente une position intermédiaire de la fixation, dans laquelle les vis ont été vissées dans les trous 22 pour mettre en contact la sole 16 du radiateur 12 avec la face non active du circuit intégré 13. Jusqu'à cette position, les clips 21 sont restés en contact avec le radiateur. En continuant de visser, la force exercée par les ressorts 18 est transmise au circuit intégré 13 et les clips 21 commencent à s'écarter de la plaque 15. La figure 2b illustre la position où les clips 21 viennent en butée avec la carte 11. Dès lors, les vis 18 peuvent être serrées jusqu'à obtenir la force de fixation Ff désirée.

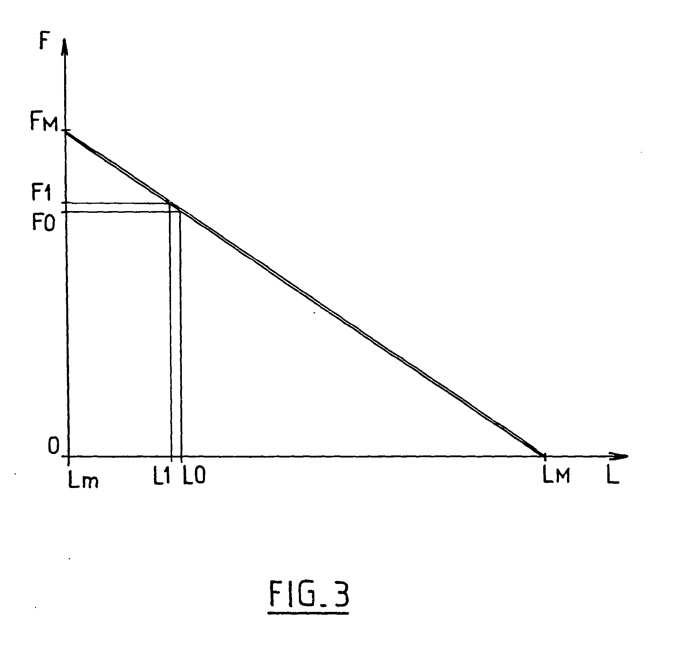

La figure 3 est un graphe illustrant les variations de la force F exercée par chaque ressort 20 en fonction de la longueur L du ressort entre ses deux extrémités. On a supposé que la force F varie linéairement en fonction inversement proportionnelle de sa longueur, depuis sa longueur maximale LM à l'état non comprimé (F = 0) et sa longueur minimale Lm quand il est complètement comprimé et exerce la force maximale FM. La longueur L0 de chaque ressort 20 est celle indiquée dans la figure 1 et conservée dans la figure 2a. Chaque ressort 20 de longueur L0 exerce la force F0. Le serrage de chaque vis 18 entre la position intermédiaire de la figure 2a et la position finale de la figure 2b se fait sur une longueur d qui comprime le ressort 20 de cette longueur, de sorte que sa longueur finale dans la position illustrée dans la figure 2b est L1 = L0 - d et exerce la force finale F1. Dans la position finale, la force de contact Fc du radiateur sur le circuit intégré est égale à la somme des quatre forces F1 exercée par les quatre ressorts 20.

Plusieurs cas sont possibles. Si, comme dans l'exemple représenté par le graphe de la figure 3, la compression initiale L_{M} - L0 pour amener le ressort 20 de son état libre à l'état comprimé indiqué à la figure 1 est sensiblement plus grande que la distance d (L_{M} - L0 >> d), alors on peut considérer que la variation d se traduira par une variation faible ou négligeable de la force F0. Dans ces conditions, on peut considérer que la force finale F1 correspondant au quart de la force de contact prédéterminée Fc est sensiblement égale à la force F0. On peut donc dire que l'ensemble des ressorts exerce initialement, quand le radiateur n'est pas monté sur la carte comme indiqué dans la figure 1, une force 4F0 sensiblement égale à la force de contact prédéterminée Fc.

Selon un autre exemple non illustré, le radiateur 12 est prévu pour un type de composant 13 ayant une épaisseur W non négligeable prédéterminée ou variant légèrement autour de cette épaisseur. Par exemple, le composant 13 peut être un boîtier de circuit intégré d'un type déterminé. On sait alors que chaque ressort aura sensiblement une longueur finale L1 = L0 - W. Par conséquent, les ressorts 20 seront initialement comprimés à la longueur L0 = L1 + W. Dans ce cas, la force totale exercée par le dispositif de fixation 10 sur le radiateur 12 en dehors de son montage sur la carte 11 peut être différente de la force prédéterminée Fc d'une valeur prédéterminée, ici correspondant à l'épaisseur W. Cette épaisseur peut bien sûr inclure d'autres épaisseurs que celle du composant lui-même. On peut donc dire que d'une manière générale le dispositif de fixation 10 sur le radiateur 12 exerce une force indépendante du montage du radiateur sur la carte 11 et en relation avec la force de contact.

Le fait que dans l'exemple illustré la force F0 est prédéterminée est un cas particulier. Ainsi, selon un autre exemple qui peut être aussi celui illustré, la force de contact prédéterminée Fc peut être une force minimale requise pour obtenir une résistance thermique minimale. Dans ce cas, l'obtention d'une force F1 quelconque supérieure à F0 est favorable, puisqu'elle diminuera la résistance thermique et améliorera l'échange thermique. Dans certains cas, la force minimale requise peut être très basse et imprécise, de sorte que l'homme du métier dispose d'une marge de valeurs très grande et que la force de contact peut être considérée comme quelconque, ou comprise dans une très large gamme de valeurs possibles.

D'autre part, la description qui précède fait bien ressortir que la fixation faite selon le procédé et le dispositif 10 de invention est parfaitement symétrique. Les vis 18, le ressort 20 et les butées 21 pourraient aussi bien être montés sur la carte 11 au niveau des trous 22 de la face opposée à celle placée vis-à-vis du radiateur 12. Les vis 18 seraient alors fixées par exemple dans les trous 19 du radiateur, ou par tout autre moyen. Ceci fait aussi apparaître que le dispositif de fixation 10 pourrait d'une manière générale inclure des moyens d'attache 18 autres que les vis illustrées, qui pourraient par exemple être des pieux fixés par rotation dans des agrafes, ou bien des brides. Les ressorts 20 peuvent aussi être des lames, par exemple, et être incorporés ou intégrés aux moyens d'attache 18, par exemple sous la forme d'au moins une bride élastique. Dans ce cas, le dispositif de fixation 10 se confond avec les moyens d'attache et les moyens à ressort.

Par ailleurs, le procédé et le dispositif de fixation 10 de l'invention peuvent aussi bien s'appliquer à tout composant électrique ou électronique dissipatif de chaleur. Il est évident aussi que le contact peut être thermique et/ou électrique. Par exemple, l'un des éléments peut servir d'électrode ou de plan de potentiel pour faire contact avec la face non active d'un circuit intégré à transistors à effet de champ, par exemple de type MOS (Métal-Oxyde-Semiconducteur). Dans l'exemple illustré, il suffirait que les écrous 23 soient connectés à un plan de potentiel, la masse par exemple, et que les écrous, les vis et le radiateur fasse une liaison électrique avec la face non active du circuit intégré pour établir un contact à la fois thermique et électrique. La carte 11 et le radiateur 12 peuvent donc être plus généralement remplacés par d'autres éléments enserrant un composant au moyen d'un dispositif de fixation 10 exerçant une force de contact sur le composant.

D'une manière générale, on peut donc dire que invention a pour objet un procédé de fixation de deux éléments 11, 12 enserrant un composant électrique ou électronique 13 au moyen d'un dispositif de fixation 10 exerçant une force de contact Fc sur le composant, le dispositif de fixation exerçant sur un premier 12 des deux éléments une force F0 indépendante du montage des deux éléments (fig. 1) et en relation avec ladite force de contact.

On a vu que la relation peut être sensiblement une égalité, ou prévoir une épaisseur W déterminée du composant, ou être quelconque. On a vu aussi que la force exercée F0 peut être prédéterminée ou quelconque.

Il est aussi remarquable dans le procédé décrit en référence aux figures 2a et 2b que le dispositif de fixation 10 exerce la force de contact Fc sensiblement indépendamment de la force de fixation Ff du dispositif de fixation au second élément 11.

Un avantage de invention peut être obtenu en fixant fermement le dispositif de fixation 10 à la carte 11 constituant le second élément dans l'exemple illustré. Le radiateur 12 est alors bien calé dans la position désirée sur la carte 11 et peu sensible aux vibrations, les ressorts servant alors à amortir les vibrations.

Un autre avantage peut encore être obtenu en rendant le dispositif de fixation relativement indépendant du premier élément 12 de façon que la force de contact Fc soit répartie uniformément sur le composant 13. Il suffirait par exemple d'élargir le diamètre des trous 19 pour rendre le radiateur 12 flottant par rapport aux vis 18 de manière à lui permettre de mieux s'ajuster à la surface de contact présentée par le composant. Le dispositif de fixation 10 pourrait alors être peu sensible aux défauts de planéité du radiateur 12 et/ou de la carte 11 et/ou du composant 13.

L'invention a donc pour objet corollaire un dispositif de fixation 10 de deux éléments 11, 12 enserrant un composant électrique ou électronique 13 et exerçant une force de contact Fc sur le composant par l'intermédiaire d'un premier 12 des deux éléments sur lequel il exerce une force indépendante du montage des deux éléments.

On a vu que le dispositif de fixation peut être quelconque et s'appliquer sur le radiateur ou sur la carte par des moyens autres que les trous 19 et 22. L'indépendance entre la force exercée par le dispositif de fixation et la fixation des deux éléments peut être obtenue avec des moyens de couplage du dispositif de fixation avec l'un des éléments, le radiateur 12 dans l'exemple illustré. Dans le cas particulier ayant servi d'exemple où le dispositif de fixation comprend des moyens d'attache 18 couplés à des moyens à ressort 20, les moyens de couplage comprennent des premiers moyens de butée 21 contre ledit premier élément. Il est évident que les moyens de butée 21 peuvent être quelconques. Par exemple, au lieu des clips illustrés, ils pourraient être constitués par une bague de faible épaisseur, solidaire du corps de la vis et de plus grande section. Dans ce cas, le passage dans les trous 19 du radiateur pourrait se faire en rendant la tête de vis amovible, par exemple en la vissant dans le corps de la vis ou en remplaçant la tête de la vis par une rondelle ou un clip. Dans ce dernier cas, on comprend que chaque vis pourrait être remplacée par un élément non fileté. Selon une autre variante, chaque butée 21 pourrait être un épaulement formé par une section plus grande du corps de vis en dessous de la butée. Les butées 21 pourraient aussi être réglables pour ajuster la force F0 à une valeur prédéterminée. Bien que la force exercée par les moyens à ressort 20 puisse être quelconque, elle peut être ajustée à une valeur prédéterminée en réglant les moyens de butée 21, comme décrit par exemple en référence à la figure 3. Les moyens de butée pourraient donc être réglables de façon à pouvoir faire cet ajustement, par exemple en remplaçant le clip par un écrou de hauteur réglable.

En référence aux figures 2a et 2b, on a vu que les butées 21 permettent de fixer les moyens d'attache 18 au radiateur 11 avec une force indépendante de ladite force de contact Fc. Cependant, ces figures font bien ressortir que les butées prévues pour rendre la force de fixation Ff du dispositif 10 à la carte 11 indépendante de la force de contact Fc pourraient être différentes des butées 21. Ce pourrait être par exemple d'autres clips placés plus bas, fixement ou de façon réglable, ou bien un épaulement solidaire d'une partie de vis de plus forte section, dont la hauteur pourrait être choisie de façon que l'épaulement supérieur joue le rôle des butées 21 relatives au radiateur 12. Bien que la force de fixation Ff décrite est totalement indépendante de la force de contact Fc, ces deux forces pourraient être liées entre elles. Par exemple, la force de fixation Ff pourrait être déterminée par un ressort lié au vissage de chaque vis conditionnant aussi la force de contact Fc. Un avantage de l'invention est de pouvoir profiter de ce lien ou de rendre ces deux forces Ff et Fc sensiblement indépendantes, par exemple en mettant comme butée de détermination de la force de fixation Ff une rondelle sensiblement conique et jouant le rôle de ressort.

Il en résulte que l'invention a pour aussi pour objet un élément 11 ou 12 pourvu du dispositif précédent 10 pour la fixation de cet élément à un autre élément 12 ou 11 et exercer une force de contact Fc sur un composant électrique ou électronique 13 enserré entre les deux éléments.

En se référant à l'exemple illustré, invention a donc plus particulièrement pour objet un radiateur 12 pour le refroidissement d'un composant électrique ou électronique et comprenant un dispositif de fixation, le radiateur constituant le premier élément dans le dispositif de fixation décrit précédemment.

Réciproquement, l'invention a aussi plus particulièrement pour objet une carte pour la connexion d'au moins un composant électrique ou électronique, la carte constituant le premier élément pourvu du dispositif de fixation 10 défini précédemment.

## Revendications

1. Dispositif de fixation (10) d'un premier élément (12) avec un second élément (11) pour enserrer un composant électrique ou électronique (13), le dispositif de fixation (10) comprenant des moyens (18) d'attache, traversant le premier élément (12), pour fixer ce dernier au second élément (11), et des moyens à ressort (20), s'appuyant sur le premier élément (12) et sur les moyens d'attache (18), pour exercer une force de contact (Fc) sur le composant (13) quand ce dernier est fixé entre les deux éléments, dispositif **caractérisé en ce que** les moyens à ressort (20) sont couplés à des moyens de butée (21) s'appuyant sur le premier élément (12), les moyens à ressort (20) exerçant sur le premier élément (12), avant la fixation des deux éléments avec lesdits moyens d'attache (18), une force (4F0) en relation avec la force de contact (Fc), les moyens de butée (21), lors de la fixation des deux éléments entre eux, viennant s'appuyer sur le second élément (11) jusqu'à obtenir la force de fixation (Ff) désirée, sensiblement indépendante de ladite force de contact (Fc).

2. Dispositif selon la revendication 1, **caractérisé en ce que** la force (4F0) exercée par les moyens à ressort (20) sur le premier élément (12) avant sa fixation est sensiblement égale à la force de contact (Fc) qu'ils exercent sur le composant (13) lorsque les deux éléments sont fixés entre eux.

3. Dispositif selon la revendication 1 ou 2, **caractérisé en ce que** la longueur (L0) des moyens à ressort détermine la force (4F0).

4. Dispositif selon la revendication 3, **caractérisé en ce que** les moyens d'attache (18) sont des vis et les moyens de ressort (20) sont des ressorts hélicoïdaux montés coaxialement aux vis.

5. Dispositif selon l'une des revendications 1 à 4, **caractérisé en ce que** les moyens d'attache (18) lient le premier élément (12) et le second élément (11) avec un débattement qui est limité par les moyens de butée (21).

6. Dispositif selon l'une des revendications 1 à 4, **caractérisé en ce que** les moyens d'attache comprennent des moyens additionnels de butée pour fixer les moyens d'attache (18) au second élément (11) avec une force (Ff) sensiblement indépendante de ladite force de contact (Fc).

7. Dispositif selon une des revendications 1 à 6, **caractérisé en ce que** le premier élément du dispositif de fixation (10) est un radiateur (12) pour le refroidissement du composant électrique ou électronique (13) monté sur une carte (11), la carte constituant le second élément du dispositif de fixation (10).

8. Dispositif selon une des revendications 1 à 6, **caractérisé en ce que** le premier élément du dispositif de fixation (10) est une carte (11) pour la connexion au moins du composant électrique ou électronique (13) et **en ce que** le second élément est un radiateur (12), qui refroidit le composant.

9. Dispositif selon une des revendications 1 à 6, **caractérisé en ce que** le dispositif de fixation (10) est constitué d'une carte (11) pourvue au moins du composant électrique ou électronique (13) et d'un radiateur (12), le radiateur refroidissant le composant électrique ou électronique (13).

## Claims

1. Device (10) for fixing a first element (12) to a second element (11) in order to enclose an electrical or electronic component (13), the fixing device (10) comprising fastening means (18), passing through the first element (12), in order to fix the latter to the second element (11), and spring means (20), bearing on the first element (12) and on the fastening means (18), in order to exert a contact force (Fc) on the component (13) when the latter is fixed between the two elements, the device being **characterised in that** the spring means (20) are coupled to stop means (21) bearing on the first element (12), the spring means (20) exerting on the first element (12), before the fixing of the two elements with said fastening means (18), a force (4F0) in relation to the contact force (Fc), the stop means (21), during the fixing of the two elements to each other, coming to bear on the second element (11) until the desired fixing force (Ff) is obtained, said fixing force being substantially independent of said contact force (Fc).

2. Device according to Claim 1, **characterised in that** the force (4F0) exerted by the spring means (20) on the first element (12) before its fixing is substantially equal to the contact force (Fc) that they exert on the component (13) when the two elements are fixed together.

3. Device according to Claim 1 or 2, **characterised in that** the length (L0) of the spring means determine the force (4F0).

4. Device according to Claim 3, **characterised in that** the fastening means (18) are screws and the spring means (20) are helical springs mounted coaxially to the screws.

5. Device according to one of Claims 1 to 4, **characterised in that** the fastening means (18) link the first element (12) and the second element (11) with clearance that is limited by the stop means (21).

6. Device according to one of Claims 1 to 4, **characterised in that** the fastening means comprise additional stop means for fixing the fastening means (18) to the second element (11) with a force (Ff) substantially independent of said contact force (Fc).

7. Device according to one of Claims 1 to 6, **characterised in that** the first element of the fixing device (10) is a radiator (12) for cooling the electrical or electronic component (13) mounted on a card (11), the card constituting the second element of the fixing device (10).

8. Device according to one of Claims 1 to 6, **characterised in that** the first element of the fixing device (10) is a card (11) for connecting at least the electrical or electronic component (13) and **in that** the second element is a radiator (12), which cools the component.

9. Device according to one of Claims 1 to 6, **characterised in that** the fixing device (10) is constituted by a card (11) provided with at least the electrical or electronic component (13) and a radiator (12), the radiator cooling the electrical or electronic component (13).

## Patentansprüche

1. Vorrichtung (10) zur Befestigung eines ersten Elements (12) mit einem zweiten Element (11), um eine elektrische oder elektronische Komponente (13) einzuklemmen, wobei die Vorrichtung (10) zur Befestigung Mittel (18) zur Anbindung enthält, die das erste Element (12) durchqueren, um letzteres am zweiten Element (11) zu befestigen, und Federmittel (20), die sich auf dem ersten Element (12) und den Mitteln zur Anbindung (18) abstützen, um eine Kontaktkraft (Fc) auf die Komponente (13) auszuüben, wenn letztere zwischen den beiden Elementen befestigt ist, wobei die Vorrichtung **dadurch gekennzeichnet ist, dass** die Federmittel (20) an Anschlagmittel (21) gekoppelt sind, die sich auf das erste Element (12) stützen, wobei die Federmittel (20) vor der Befestigung der beiden Elemente mit den genannten Anbindungsmitteln (18) eine Kraft (4F0) auf das erste Element (12) ausüben, die in Relation zur Kontaktkraft (Fc) steht, wobei die Anschlagmittel (21) bei der Befestigung der beiden Elemente untereinander auf das zweite Element (11) abgestützt werden, bis zum Erreichen der gewünschten Befestigungskraft (Ff), die im Wesentlichen unabhängig von der genannten Kontaktkraft (Fc) ist.

2. Vorrichtung nach Anspruch 1, **dadurch gekennzeichnet, dass** die Kraft (4F0), die von den Federmitteln (20) auf das erste Element (12) vor seiner Befestigung ausgeübt wird, im Wesentlichen gleich der Kontaktkraft (Fc) ist, die sie auf die Komponente (13) ausüben, wenn die beiden Elemente untereinander befestigt sind.

3. Vorrichtung nach Anspruch 1 oder 2, **dadurch gekennzeichnet, dass** die Länge (L0) der Federmittel die Kraft (4F0) bestimmt.

4. Vorrichtung nach Anspruch 3, **dadurch gekennzeichnet, dass** die Anbindungsmittel (18) Schrauben sind, und dass die Federmittel (20) Schraubfedern sind, die koaxial mit den Schrauben montiert sind.

5. Vorrichtung nach einem der Ansprüche 1 bis 4, **dadurch gekennzeichnet, dass** die Anbindungsmittel (18) das erste Element (12) und das zweite Element (11) mit einem Spiel miteinander verbinden, der durch die Anschlagsmittel (21) begrenzt ist.

6. Vorrichtung nach einem der Ansprüche 1 bis 4, **dadurch gekennzeichnet, dass** die Anbindungsmittel zusätzliche Anschlagmittel enthalten zur Befestigung der Anbindungsmittel (18) an dem zweiten Element (11) mit einer Kraft (Ff), die im Wesentlichen unabhängig von der genannten Kontaktkraft (Fc) ist.

7. Vorrichtung nach einem der Ansprüche 1 bis 6, **dadurch gekennzeichnet, dass** das erste Element der Befestigungsvorrichtung (10) ein Kühler (12) zur Kühlung der auf einer Karte montierten elektrischen oder elektronischen Komponente (13) ist, wobei die Karte das zweite Element der Befestigungsvorrichtung (10) bildet.

8. Vorrichtung nach einem der Ansprüche 1 bis 6, **dadurch gekennzeichnet, dass** das erste Element der Befestigungsvorrichtung (10) eine Karte (11) zur Verbindung von mindestens der elektrischen oder elektronischen Komponente (13) ist, und dass das zweite Element ein Kühler (12) ist, der die Komponente kühlt.

9. Vorrichtung nach einem der Ansprüche 1 bis 6, **dadurch gekennzeichnet, dass** die Befestigungsvorrichtung (10) aus einer Karte (11), die mindestens mit der elektrischen oder elektronischen Komponente (13) bestückt ist, und einem Kühler (12) besteht, wobei der Kühler die elektrische oder elektronische Komponente (13) kühlt.
